# FASCICULE DE BREVET EUROPEEN

(11) **EP 3 055 248 B1**
(45) Date de publication et mention de la délivrance du brevet: **26.07.2017**
(21) Numéro de dépôt: 14784327.0
(22) Date de dépôt: 23.09.2014
(51) Int. Cl.: B81C 1/00, C23C 16/44, C23C 16/04, C23C 16/455, C23C 16/513

(54) **PROCEDE ET SYSTEME DE STRUCTURATION SUBMICROMETRIQUE D'UNE SURFACE DE SUBSTRAT**
VERFAHREN UND SYSTEM ZUR SUBMIKROMETRISCHEN STRUKTURIERUNG EINER SUBSTRATOBERFLÄCHE
METHOD AND SYSTEM FOR SUBMICROMETRIC STRUCTURING OF A SUBSTRATE SURFACE

(30) Priorité: 07.10.2013 FR 1359713
(43) Date de publication de la demande: 17.08.2016
(73) Titulaire: Centre National de la Recherche Scientifique, 75016 Paris (FR)
(72) Inventeur: BELMONTE, Thierry, F-54230 Neuves-Maisons (FR); AMARAL, Thiago Silva, Parana (BR); GRIES, Thomas, F-54460 Liverdun (FR); NOEL, Cédric, F-54100 Nancy (FR); CARDOSO, Rodrigo Perito, 80820-349 Vista Alegre Curitiba Parana (BR)
(74) Mandataire: Petit, Maxime
(86) Numéro de dépôt international: PCT/FR2014/052357
(87) Numéro de publication internationale: WO 2015/052396

(56) Documents cités:
- EP-A1- 2 309 020
- JP-A- 2006 274 290
- Hervé Dallaporta ET AL: "Construction d'objets à l'échelle submicronique", CNRIUT 2008 - XIV Colloque National de la Recherche dans les IUT IUT A et IUT B, 29 mai 2008 (2008-05-29), XP055116510, Extrait de l'Internet: URL:http://liris.cnrs.fr/~cnriut08/actes/a rticles/112.pdf [extrait le 2014-05-06] cité dans la demande

## Description

La présente invention concerne de manière générale la structuration d'une surface d'un substrat, en particulier en vue de la réalisation d'objets bidimensionnels (objets 2D) ou tridimensionnels (objets 3D).

Par structuration, on entend l'ajout ou le retrait de matériaux.

Les domaines d'application plus spécifiquement visés par l'invention sont tous les secteurs dans lesquels on cherche à obtenir de fortes résolutions spatiales des motifs réalisés sur les surfaces (réalisation d'écran OLED, micromécanique et MEMS, micro-réacteurs pour laboratoire sur puce, électronique, etc.).

On connaît déjà des procédés permettant de fabriquer des objets 3D à l'échelle submicronique. Le document intitulé « Construction d'objets à l'échelle submicronique » (Hervé Dallaporta, Frédéric Bedu, accessible au lien http://liris.cnrs.fr/∼cnriut08/actes/articles/112.pdf) décrit en particulier une méthode de construction d'objets à des échelles submicroniques par décomposition de précurseurs assistée par un faisceau d'ions focalisé. Pour obtenir le dépôt d'un matériau sur une surface, on amène par voie gazeuse un précurseur contenant les éléments chimiques constituant le matériau. Chaque point de la construction est ensuite exposé à des ions focalisés pour obtenir une décomposition du précurseur la plus localisée possible. Dans cette méthode, la résolution obtenue est fonction de la finesse du faisceau d'ions que l'on est capable de générer. Bien que cette technique ait fait ses preuves, sa mise en oeuvre reste complexe et très coûteuse du fait que le faisceau d'ions doit être généré sous vide.

Le domaine de la fabrication tridimensionnelle (ou 3D manufacturing) est actuellement en plein essor. D'abord développée pour le prototypage rapide, cette technique de fabrication additive est de plus en plus utilisée par les industriels pour la production à grande échelle, voire par des particuliers pour la réalisation d'objets personnalisés.

La fabrication additive consiste à empiler des couches une par une de façon à construire un objet complet à partir des données numériques d'un modèle 3D. En d'autres termes, l'objet que l'on souhaite obtenir est d'abord modélisé en trois dimensions, par exemple à l'aide d'un outil de CAO. Le fichier 3D obtenu est ensuite envoyé vers un appareillage spécifique qui traite le fichier 3D de manière à trancher l'objet virtuel 3D suivant une orientation donnée en des coupes parallèles d'épaisseur déterminée. Les appareillages connus utilisés diffèrent en particulier en fonction :
- des matériaux de base utilisés, ces derniers se présentant généralement sous forme de liquide, de poudre, de fil ou de ruban ;
- de l'énergie utilisée pour la mise en forme, celle-ci provenant généralement d'une source laser, d'une source de lumière visible, infrarouge ou ultraviolet, ou encore d'une source de chaleur ; et
- du processus de mise en forme physique (par exemple fusion puis solidification, frittage) ou chimique (polymérisation ou réticulation) utilisé.

Ainsi et à titre d'exemples, les techniques dites de fusion sélective par laser ou SLM (initiales anglo-saxonnes mises pour Selective Laser Melting) et de frittage sélectif par laser ou SLS (initiales anglo-saxonnes mises pour Selective Laser sintering) associent un faisceau laser à une poudre métallique ou plastique pour faire fondre ou fritter la poudre.

La technique de projection de liant, très inspirée des imprimantes 2D à jet d'encre, consiste à imprégner une couche de poudre céramique, plastique ou métallique d'un liant au moyen d'une buse de projection de liant mobile sur deux axes. Le processus de solidification peut être accéléré par l'utilisation d'un éclairage ultraviolet.

La technique du modelage à jets multiples, consistent à déposer une couche de résine liquide.

D'autres techniques, comme le modelage par dépôt en fusion ou FDM (initiales anglo-saxonnes mises pour Fused Deposition Modeling) utilisent une buse chauffante pilotée selon un algorithme pour extruder un filament qui se dépose à une température légèrement inférieure au point de fusion du matériau du filament et se solidifie quasiment instantanément à sa mise en contact avec la couche précédente.

Toutes ces techniques d'impression tridimensionnelle présentent l'énorme avantage d'être beaucoup moins coûteuses à mettre en oeuvre, du fait notamment qu'elles ne nécessitent pas d'équipements complexes avec des chambres sous vide.

Néanmoins, les résultats en termes de résolution spatiale restent encore trop limités pour envisager de les appliquer aux domaines visés par la présente invention. En effet, dans les meilleurs cas, on peut espérer obtenir des résolutions de l'ordre de quelques dizaines de micromètres, alors que les domaines visés requièrent des résolutions de l'ordre de la centaine de nanomètres.

On connait par ailleurs, notamment dans l'industrie du semiconducteur, des procédés pour produire des couches minces qui utilisent des jets de micro plasmas à pression atmosphérique pour faire réagir un ou plusieurs précurseurs gazeux au(x)quel(s) un substrat est exposé. Les documents KR2012005870A et JP2006274290A décrivent notamment des procédés dans lesquels le précurseur et le plasma sont mélangés dans un même tube capillaire. Dans ce type de techniques, la zone de dépôt correspond néanmoins à la taille du plasma, qui est elle-même limitée par la longueur de Debye. Or, à ce jour, on ne sait pas créer de plasma à pression atmosphérique dont la taille soit inférieure à 30 microns.

L'invention a pour but de pallier les inconvénients des différentes techniques précitées en proposant un procédé et un système pour la structuration d'une surface d'un substrat qui permette, à moindre coût, d'obtenir des résolutions spatiales submicrométriques.

Pour ce faire, la présente invention a pour objet un procédé de structuration submicrométrique d'une surface d'un substrat comprenant les étapes suivantes:génération d'un plasma à pression atmosphérique au-dessus de ladite surface; injection sur ladite surface, au travers dudit plasma, d'au moins un précurseur gazeux au moyen d'au moins un capillaire de diamètre submicrométrique le précurseur gazeux et le plasma étant choisis en fonction de la structuration submicrométrique à réaliser.

Avec ce procédé, on obtient des tailles de dépôt ou de gravure qui ne dépendent plus de la taille du plasma utilisé et qui peuvent être réduites au diamètre submicrométrique du capillaire utilisé pour injecter le précurseur gazeux.

Selon d'autres caractéristiques possibles du procédé :
- le précurseur gazeux et le plasma sont choisis pour réaliser soit une gravure localisée, soit un dépôt localisé ;
- plusieurs précurseurs gazeux peuvent être utilisés successivement par l'intermédiaire du même capillaire, ou successivement par l'intermédiaire d'une pluralité de capillaires de diamètres submicrométriques, ou simultanément dans une pluralité de capillaires de diamètres submicrométriques ;
- le plasma généré à pression atmosphérique est de préférence un plasma froid ;
- le capillaire présente avantageusement un diamètre de l'ordre de 100 nanomètres ;
- le procédé peut comporter en outre une étape de chauffage localisé du substrat, pour accroître la cinétique de la réaction chimique du précurseur gazeux et du plasma.

L'invention a également pour objet un système pour la structuration submicrométrique d'une surface d'un substrat, ledit système comportant:
au moins une source de plasma apte à générer un plasma à pression atmosphérique au-dessus de ladite surface ;
au moins un capillaire de diamètre submicrométrique pour l'injection sur ladite surface d'au moins un précurseur gazeux au travers dudit plasma.

Conformément à des modes de réalisation possibles :
- le système peut comporter en outre des moyens aptes à permettre un mouvement relatif entre d'une part, le substrat, et d'autre part, l'ensemble constitué par ledit au moins un capillaire et ladite au moins une source de plasma, par exemple une platine mobile dans au moins deux directions orthogonales, parallèles à ladite surface ;
- la platine peut en outre être également mobile selon une direction orthogonale à ladite surface ;
- un moyen de contrôle apte à assurer une distance de sécurité minimale entre l'extrémité du capillaire et ladite surface est avantageusement prévu pour éviter d'endommager le capillaire.

L'invention sera mieux comprise au vu de la description détaillée suivante, faite en référence aux figures annexées, dans lesquelles :
- la figure 1 représente des étapes conformes au procédé de structuration selon l'invention ;
- la figure 2 est un exemple de courbes expérimentales obtenues avec différents diamètres de capillaire ;
- les figures 3 (a) à (c) représentent en vue de dessus des exemples de dépôts obtenus sur une surface de substrat ;
- la figure 4 illustre schématiquement un système expérimental pour la mise en oeuvre du procédé de la figure 1, pour une application d'impression tridimensionnelle.

La présente invention est partie de l'idée générale d'utiliser le principe d'une imprimante à jet d'encre en remplaçant l'encre par un gaz précurseur, plus facile à manipuler qu'un liquide, et en utilisant, pour la mise en forme, un plasma généré sous pression atmosphérique.

Comme cela a été indiqué précédemment, les techniques jusqu'ici utilisées associant un gaz précurseur mélangé à un plasma n'ont pas permis de réaliser des dépôts de taille inférieure à environ 30 microns, qui correspond à la taille du plasma généré.

La présente invention propose de séparer complètement l'injection du gaz précurseur de celle du plasma. Les essais menés par la Demanderesse ont en effet montré qu'il est possible d'obtenir, sur la surface d'un substrat, un dépôt de matière dont la taille correspond sensiblement au diamètre d'un jet de gaz précurseur dirigé vers la surface et passant au travers d'un volume de plasma généré à pression atmosphérique à proximité de la surface. Il est donc possible d'amener un gaz précurseur de façon très localisée sur la surface d'un substrat grâce à l'utilisation d'un capillaire de très faible diamètre, tel que ceux utilisés en médecine, notamment pour manipuler des ovules. Ces capillaires sont des tubes en verre qui ont été étirés et dont les pointes sont forgées pour atteindre des dimensions très réduites, variant typiquement de 100 nanomètres à quelques microns.

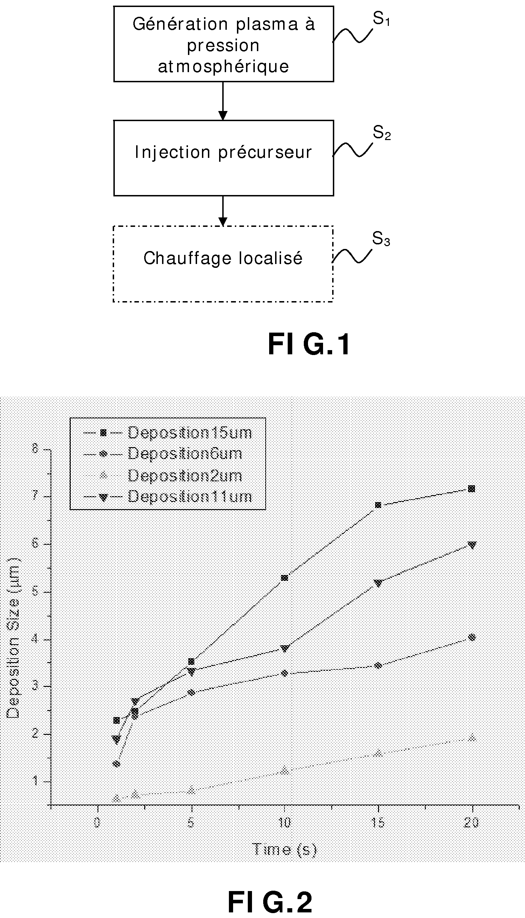

La figure 1 schématise les étapes d'un procédé conforme à l'invention pour l'obtention d'une zone structurée sur la surface d'un substrat. On génère tout d'abord un plasma à pression atmosphérique au-dessus du substrat, à proximité de la surface du substrat (étape S₁), puis on injecte, de préférence à haute pression, un précurseur gazeux au moyen d'un capillaire de diamètre submicrométrique (étape S₂). Le jet de gaz est dirigé sur la surface et traverse le plasma. La réaction du précurseur avec le gaz du plasma permet de réaliser des structurations ponctuelles de taille submicrométrique. La pression utilisée pour injecter le gaz précurseur dépend du diamètre du capillaire et de la nature du gaz précurseur. On peut travailler typiquement à des pressions situées entre 1 et 100 bars.

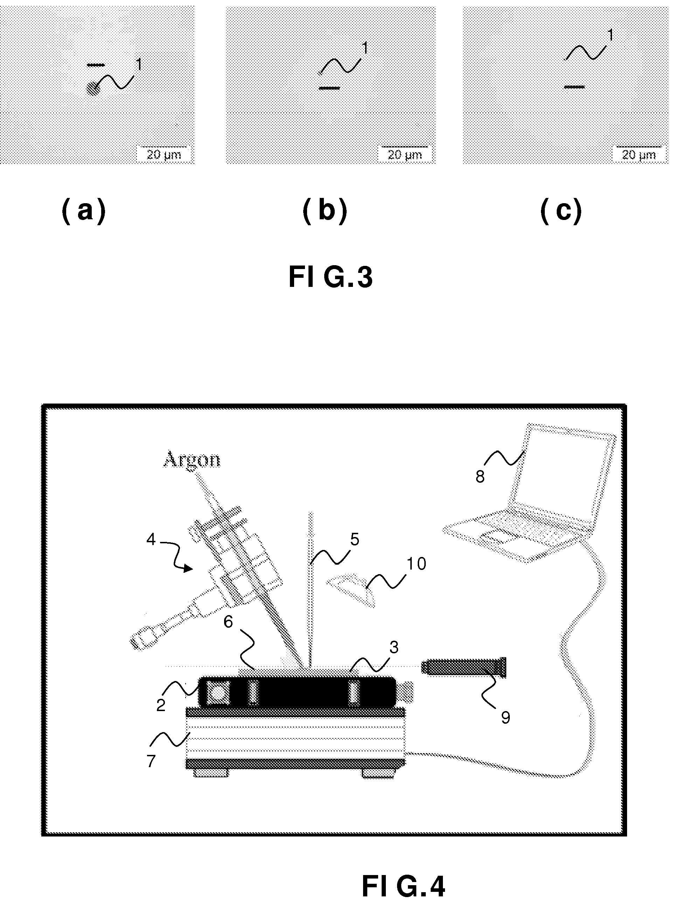

La figure 2 illustre, à titre d'exemples, l'évolution des tailles de dépôt de carbone obtenues au cours du temps pour des essais réalisés avec quatre capillaires de diamètres différents (2 microns, 6 microns, 11 microns et 15 microns) utilisés pour injecter de l'acétylène au travers d'un plasma d'Argon généré à pression atmosphérique. La taille minimale atteinte est de 700 nm, ce qui est environ 40 fois inférieure à la taille minimale des imprimantes 3D commerciales. Les figures 3 (a), (b) et (c) illustrent en vue de dessus trois exemples de spots 1 de différentes tailles obtenus.

La nature de la structuration dépend du choix du gaz précurseur et du plasma. Certaines associations permettront l'obtention d'un dépôt alors que d'autres génèreront une gravure. En outre, en fonction du choix des gaz précurseurs, on peut obtenir des dépôts de nature variée, tels que des métaux, des céramiques et des polymères plasma.

Le plasma utilisé peut être de préférence un plasma froid. Il doit être généré à pression atmosphérique. Il peut être de toute taille supérieure au diamètre du capillaire. Il peut être excité en continu ou à différentes fréquences, être pulsé ou non, permettre un apport thermique servant de chauffage simultanée de la surface comme par exemple les plasmas micro-ondes ou fonctionner à température ambiante pour déposer des matériaux labiles, comme par exemple les plasmas impulsionnels. Dans certains cas, une étape S₃ de chauffage localisé du substrat peut être prévue dans le but d'accélérer la réaction chimique du précurseur gazeux et du plasma.

En fonction de l'objet 2D ou 3D que l'on souhaite réaliser, on peut prévoir d'utiliser plusieurs capillaires de diamètres submicrométriques identiques ou non permettant d'injecter simultanément un même ou plusieurs précurseurs gazeux au travers du même plasma. En variante, un même capillaire peut éventuellement être utilisé pour injecter successivement plusieurs gaz précurseurs.

La figure 4 illustre de façon schématique un système mettant en oeuvre le procédé pour la réalisation d'un objet 3D avec des résolutions submicrométriques :

Le système comporte une platine 2 destinée à recevoir un substrat 3, un dispositif 4 générateur de plasma froid, et un capillaire 5 positionné au-dessus de la surface 6 du substrat 3. La platine 2 est de préférence posée sur une table 7 anti vibration à laquelle le dispositif 4 et le capillaire 5 sont fixés. La platine 2 est mobile selon au moins deux directions orthogonales dans un plan parallèle à la surface 6, et une troisième direction orthogonale aux deux autres. Le déplacement de la platine 2 est piloté par un moyen logiciel 8 (représenté ici sous la forme d'un ordinateur) en fonction de l'objet virtuel 3D que l'on souhaite réaliser. Une optique de positionnement 9 permet de garantir l'existence d'une distance de sécurité entre la surface 6 du substrat et la pointe du capillaire 5 lors du déplacement vertical de la platine 2, afin de protéger le capillaire 5. Un moyen 10 de chauffage peut être prévu pour permettre d'augmenter la cinématique de la réaction entre le précurseur gazeux et le plasma. La vitesse de déplacement de la platine 2 est calculée en fonction de différents paramètres, en particulier la vitesse de dépôt ou de gravure. Si différents précurseurs sont utilisés successivement, un moyen de purge (non représenté) est avantageusement prévu pour nettoyer le capillaire entre deux injections. Dans d'autres systèmes, on peut bien entendu prévoir d'avoir plusieurs capillaires fixés au-dessus de la table.

Grâce au procédé selon l'invention, on peut réaliser des structurations de surface de substrat à très fortes résolutions, notamment des impressions 2D ou 3D et/ou des gravures, avec des équipements peu coûteux. A ce jour, les résolutions susceptibles d'être obtenues sont limitées uniquement par le diamètre des capillaires utilisés (aujourd'hui de l'ordre de 100 nanomètres) et pourront donc être encore améliorées en fonction de l'évolution des techniques de fabrication des capillaires de diamètres encore plus faibles.

## Revendications

1. Procédé de structuration submicrométrique d'une surface (6) d'un substrat (3) comprenant les étapes suivantes:
génération (S₁) d'un plasma à pression atmosphérique au-dessus de ladite surface (6);
injection (S₂) sur ladite surface (3), au travers dudit plasma, d'au moins un précurseur gazeux au moyen d'au moins un capillaire (5) de diamètre submicrométrique,
le précurseur gazeux et le plasma étant choisis en fonction de la structuration submicrométrique à réaliser.

2. Procédé selon la revendication 1, **caractérisé en ce que** le précurseur gazeux et le plasma sont choisis pour réaliser une gravure localisée.

3. Procédé selon la revendication 1, **caractérisé en ce que** le précurseur gazeux et le plasma sont choisis pour réaliser un dépôt localisé.

4. Procédé selon la revendication 3, **caractérisé en ce que** plusieurs précurseurs gazeux sont injectés successivement dans ledit au moins un capillaire (5), ou successivement dans une pluralité de capillaires de diamètres submicrométriques, ou simultanément dans une pluralité de capillaires de diamètres submicrométriques.

5. Procédé selon l'une quelconque des revendications précédentes, **caractérisé en ce que** le plasma généré à pression atmosphérique est un plasma froid.

6. Procédé selon l'une quelconque des revendications précédentes, **caractérisé en ce que** le capillaire (5) présente un diamètre de l'ordre de 100 nanomètres.

7. Procédé selon l'une quelconque des revendications précédentes, **caractérisé en ce qu'**il comporte en outre une étape (S₃) de chauffage localisé du substrat.

8. Système pour la structuration submicrométrique d'une surface (6) d'un substrat (3), ledit système comportant:
au moins une source (4) de plasma apte à générer un plasma à pression atmosphérique au-dessus de ladite surface (6) ;
au moins un capillaire (5) de diamètre submicrométrique pour l'injection sur ladite surface (6) d'au moins un précurseur gazeux au travers dudit plasma.

9. Système selon la revendication 8, **caractérisé en ce qu'**il comporte en outre des moyens (2, 8) aptes à permettre un mouvement relatif entre d'une part, le substrat, et d'autre part, l'ensemble constitué par ledit au moins un capillaire (5) et ladite au moins une source (4) de plasma.

10. Système selon la revendication 8, **caractérisé en ce que** lesdits moyens comportent une platine (2) mobile dans au moins deux directions orthogonales, parallèles à ladite surface (6).

11. Système selon la revendication 10, **caractérisé en ce que** ladite platine (2) est en outre mobile selon une direction orthogonale à ladite surface (6).

12. Système selon la revendication 11, **caractérisé en ce qu'**il comporte en outre un moyen (9) de contrôle apte à assurer une distance de sécurité minimale entre l'extrémité du capillaire et ladite surface.

## Patentansprüche

1. Verfahren zur submetrischen Strukturierung einer Fläche (6) eines Substrats (3), umfassend die folgenden Schritte:
Erzeugen (S₁) eines Plasmas bei atmosphärischem Druck auf der Fläche (6),
Einleiten (S₂), auf die Fläche (3), durch das Plasma mindestens eines gasförmigen Vorläufers mittels mindestens einer Kapillare (5) mit submikrometrischem Durchmesser,
wobei der gasförmige Vorläufer und das Plasma in Abhängigkeit von der herzustellenden submikrometrischen Strukturierung gewählt sind.

2. Verfahren nach Anspruch 1, **dadurch gekennzeichnet, dass** der gasförmige Vorläufer und das Plasma ausgewählt sind, um eine lokalisierte Gravur herzustellen.

3. Verfahren nach Anspruch 1, **dadurch gekennzeichnet, dass** der gasförmige Vorläufer und das Plasma ausgewählt sind, um eine lokalisierte Ablagerung herzustellen.

4. Verfahren nach Anspruch 3, **dadurch gekennzeichnet, dass** mehrere gasförmige Vorläufer nacheinander in die mindestens eine Kapillare (5) oder nacheinander in eine Vielzahl von Kapillaren mit submikrometrischen Durchmessern oder gleichzeitig in eine Vielzahl von Kapillaren mit submikrometrischen Durchmessern eingeleitet werden.

5. Verfahren nach einem der vorangehenden Ansprüche, **dadurch gekennzeichnet, dass** das bei atmosphärischem Druck erzeugte Plasma ein kaltes Plasma ist.

6. Verfahren nach einem der vorangehenden Ansprüche, **dadurch gekennzeichnet, dass** die Kapillare (5) einen Durchmesser von zirka 100 Nanometern aufweist.

7. Verfahren nach einem der vorangehenden Ansprüche, **dadurch gekennzeichnet, dass** es ferner einen Schritt (S₃) des lokalisierten Erwärmens des Substrats aufweist.

8. System zur submetrischen Strukturierung einer Fläche (6) eines Substrats (3), wobei das System umfasst:
mindestens eine Plasmaquelle (4), die imstande ist, ein Plasma bei atmosphärischem Druck auf der Fläche (6) zu erzeugen,
mindestens eine Kapillare (5) mit submikrometrischem Durchmesser für das Einleiten auf die Fläche (6) mindestens eines gasförmigen Vorläufers durch das Plasma.

9. System nach Anspruch 8, **dadurch gekennzeichnet, dass** es ferner Mittel (2, 8) aufweist, die imstande sind, eine relative Bewegung zwischen zum einen dem Substrat und zum anderen der Einheit zu erlauben, die von der mindestens einen Kapillare (5) und der mindestens einen Plasmaquelle (4) gebildet ist.

10. System nach Anspruch 8, **dadurch gekennzeichnet, dass** die Mittel eine Platte (2) aufweisen, die in mindestens zwei orthogonalen, zu der Fläche (6) parallelen Richtungen bewegbar sind.

11. System nach Anspruch 10, **dadurch gekennzeichnet, dass** die Platte (2) ferner in einer zu der Fläche (6) orthogonalen Richtung bewegbar ist.

12. System nach Anspruch 11, **dadurch gekennzeichnet, dass** es ferner ein Steuerungsmittel (9) aufweist, das imstande ist, einen minimalen Sicherheitsabstand zwischen dem Ende der Kapillare und der Fläche zu sichern.

## Claims

1. A method for submicrometric structuration of a surface (6) of a substrate (3) comprising the following steps:
generating (S₁) an atmospheric pressure plasma above said surface (6);
injecting (S₂) on said surface (3), through said plasma, at least one gas precursor by means of a capillary (5) with submicrometric diameter,
the gas precursor and the plasma being selected according to the submicrometric structuration to be achieved.

2. The method according to claim 1, **characterized in that** the gas precursor and the plasma are selected for producing localized etching.

3. The method according to claim 1, **characterized in that** the gas precursor and the plasma are selected for producing a localized deposit.

4. The method according to claim 3, **characterized in that** several gas precursors are successively injected into said at least one capillary (5), or successively into a plurality of capillaries with submicrometric diameters, or simultaneously into a plurality of capillaries with submicrometric diameters.

5. The method according to any of the preceding claims, **characterized in that** the plasma generated at atmospheric pressure is a cold plasma.

6. The method according to any of the preceding claims, **characterized in that** the capillary (5) has diameter of the order of 100 nanometers.

7. The method according to any of the preceding claims, **characterized in that** it further comprises a step (S₃) for localized heating of the substrate.

8. A system for submicrometric structuration of a surface (6) of a substrate (3), said system including:
at least one plasma source (4) able to generate a plasma at atmospheric pressure above said surface (6);
at least one capillary (5) with submicrometric diameter, for injecting on said surface (6) at least one gas precursor through said plasma.

9. The system according to claim 8, **characterized in that** it further comprises means (2, 8) able to allow a relative movement between on the one hand, the substrate, and on the other hand, the assembly formed with said at least one capillary (5) and with said at least one plasma source (4).

10. The system according to claim 8, **characterized in that** said means include a movable plate (2) in at least two orthogonal directions, parallel to said surface (6).

11. The system according to claim 10, **characterized in that** said plate (2) is further movable along a direction orthogonal to said surface (6).

12. The system according to claim 11, **characterized in that** it further includes a control means (9) able to ensure a minimum safety distance between the end of the capillary and said surface.
